# FASCICULE DE BREVET EUROPEEN

(11) **EP 2 339 647 B1**
(45) Date de publication et mention de la délivrance du brevet: **09.11.2011**
(21) Numéro de dépôt: 10306305.3
(22) Date de dépôt: 26.11.2010
(51) Int. Cl.: H01L 31/103

(54) **Photodétecteur à structure plasmon**
Photodetektor mit Plasmonstruktur
Photodetector with plasmon structure

(30) Priorité: 24.12.2009 FR 0959567
(43) Date de publication de la demande: 29.06.2011
(73) Titulaire: Commissariat à l'Énergie Atomique et aux Énergies Alternatives, 75015 Paris (FR)
(72) Inventeur: Gravrand, Olivier, 38120, FONTANIL CORNILLON (FR); Destefanis, Gérard, 38120, SAINT EGREVE (FR); Le Perchec, Jérôme, 38000, GRENOBLE (FR)
(74) Mandataire: Vuillermoz, Bruno

(56) Documents cités:
- EP-B1- 1 247 301
- FR-A1- 2 842 945
- US-A1- 2009 146 198

## Description

### DOMAINE DE L'INVENTION

La présente invention a trait au domaine de la détection de rayonnement électromagnétique, et notamment infrarouge, à l'aide de structures métalliques dites «structures plasmon ».

### ETAT DE LA TECHNIQUE

Un mode de détection connu d'un rayonnement infrarouge consiste à réaliser l'absorption de ce rayonnement par une couche de matériau semi-conducteur à petit gap, comme par exemple du CdHgTe. L'absorption des photons par cette couche crée alors des paires électron-trou et les porteurs minoritaires ainsi produits diffusent ou dérivent sous l'effet d'un champ électrique dans la couche d'absorption pour être collectés au niveau de jonctions pn puis d'électrodes. La qualité de la détection est alors principalement dictée par les dimensions de la couche d'absorption.

En effet, le rendement quantique de la détection est d'autant meilleur que cette couche est épaisse. Dans le même temps, le courant d'obscurité, qui constitue l'une des principales sources de bruit dans ce type de détection, est quant à lui d'autant plus élevé que le volume de collection des photo-porteurs est important. Ainsi, la conception d'une telle détection relève du compromis entre l'efficacité de la détection, défini par le rendement quantique, et la quantité de bruit présent dans le signal issu de la détection, pour partie induit par le courant d'obscurité.

Pour pallier ce problème, on a proposé des photodétecteurs du type métal-semi-conducteur-métal (photodetecteur « MSM ») avec des structures métalliques, dites structures « plasmon », disposées sur ou dans la couche d'absorption. De cette manière, un couplage est obtenu pour le rayonnement électromagnétique incident avec des plasmons de surface. Un choix approprié desdites structures, prenant usuellement la forme de poutres rectilignes et parallèles à section rectangulaire, permet alors un confinement très important du champ électromagnétique dans la couche d'absorption, induisant ainsi une réduction importante du courant d'obscurité.

Outre le confinement du champ électromagnétique dans un volume restreint, les structures plasmon permettent également, sous certaines conditions géométriques, de diminuer le temps de réponse du détecteur, qui est lié à la vitesse de diffusion des porteurs dans la couche d'absorption, ou d'appliquer un filtrage spectral ou une sélectivité de polarisation. Le document US 2009/0146198 montre un photodétecteur utilisant une résonance plasmonique.

On connaît du document EP1247301 BI un photodétecteur MSM à structures plasmon comportant des poutrelles métalliques qui alternent avec des poutrelles semi-conductrices, cet ensemble étant formé sur une couche électriquement isolante. Les poutrelles métalliques forment les structures plasmon et concentrent ainsi le champ électromagnétique dans les poutrelles semi-conductrices. Toutefois, les poutrelles métalliques jouent également le rôle d'électrode de collecte des photo-porteurs créés au sein des poutrelles semi-conductrices.

Le temps de réponse d'un tel photodétecteur est principalement dicté par le temps mis entre l'instant de création d'un photo-porteur par un photon absorbé par le matériau semi-conducteur et l'instant de collecte de ce photo-porteur par les électrodes de collecte. Pour diminuer ce temps de collecte, il convient par conséquent de diminuer la durée de diffusion des photo-porteurs dans le matériau semi-conducteur, ici les poutrelles semi-conductrices.

Dans la configuration précédente, la géométrie des électrodes est imposée par la résonnance plasmon exploitée dont la géométrie est déterminée et fixée en fonction de la longueur d'onde que l'on souhaite détecter. Le moyen de diminuer le temps de collecte est alors d'utiliser une architecture dite de « peignes interdigités » où deux poutrelles consécutives sont polarisées différemment permettant ainsi la collecte par les jonctions métal-semiconducteur formées par les poutrelles en contact avec le matériau absorbant. Le principal inconvénient de ce type de structure est donc que pour profiter de sa vitesse maximum, cette architecture impose deux contacts par pixels.

De même, le document FR-A-2 842 945 propose de former des poutrelles métalliques formant structure plasmon sur une couche semi-conductrice et de prévoir une couche réfléchissante sous la structure semi-conductrice afin d'obtenir un phénomène de concentration du champ électromagnétique dans la couche semi-conductrice supportant les poutrelles métalliques. Les poutrelles électriques jouent encore ici le rôle d'électrodes de collecte de sorte que le même problème connectique est observé.

### EXPOSE DE L'INVENTION

Le but de la présente invention est de résoudre le problème susmentionné en proposant un photodétecteur apte à détecter un rayonnement électromagnétique, dont le temps de réponse est optimal quelle que soit la structure plasmon utilisée.

A cet effet, l'invention a pour objet un photodétecteur comprenant :
■ une couche semi-conductrice dopée d'absorption dudit rayonnement, apte à transformer ce dernier en porteurs de charge ;
■ une couche réflectrice du rayonnement incident non absorbé par la couche semi-conductrice en direction de cette dernière, agencée sous la couche semi-conductrice; et
■ une structure métallique agencée sur la couche semi-conductrice, et formant avec cette dernière un résonateur par excitation d'un mode plasmon de surface de manière à concentrer un champ électromagnétique incident (le rayonnement électromagnétique incident) sur la structure métallique dans des zones de concentration de champ de la couche semi-conductrice dopée.

Selon l'invention, des zones semi-conductrices de collecte des porteurs de charge générés par la couche semi-conductrice, de dopage opposé au dopage de ladite couche semi-conductrice, sont formées dans la couche semi-conductrice et présentent une topologie complémentaire de celle des zones de concentration de champ.

Par topologie complémentaire, on entend ici que les zones semi-conductrices sont agencées aux emplacements de la couche semi-conductrice exempts de zones de concentration de champ. Les zones de concentration de champ et les zones semi-conductrices de collecte forment ainsi des négatifs l'une de l'autre.

En d'autres termes, les zones semi-conductrices formées dans la couche semi-conductrice d'absorption, forment donc avec celle-ci des jonctions PN et par conséquent des zones de collecte des porteurs de charge créés dans ladite couche. Chaque zone semi-conductrice collecte les porteurs dans son voisinage immédiat. Or ce voisinage immédiat est constitué des zones de concentration de champ électromagnétique où sont créés les porteurs de charge par absorption. Ainsi chacune de zones de concentration de champ est en contact avec une jonction PN de collecte, de sorte que la durée de diffusion des porteurs de charge est minimale.

En outre, en formant un réseau de zones semi-conductrices, il est ainsi obtenu une pluralité d'éléments unitaires de détection, et donc une détection bidimensionnelle, et cela sans fabrication d'éléments unitaires distincts reportés ensuite sur un support. Notamment, les structures métalliques dites structures plasmon peuvent être continues sur toute la surface du photodétecteur si l'application le nécessite.

Selon un mode de réalisation :
■ la structure métallique comporte des structures (réseau de poutrelles, de plots ou de trous, etc...) espacées les unes des autres, la géométrie et l'espacement des structures entre elles étant choisis de sorte que les zones de concentration de champ sont réalisées entre les structures ;
■ et les zones semi-conductrices de collecte sont réalisées sous les structures et présentent la même topologie que celles-ci.

Notamment, les structures sont agencées au contact des zones semi-conductrices de collecte.

En d'autres termes, ce mode de réalisation est particulièrement adapté au cas où le champ électromagnétique est confiné entre les structures. En outre, la fabrication d'un tel photodétecteur est simplifiée et précise dans la mesure où la formation des structures, par exemple des poutrelles, peut être réalisée, par exemple par gravure, en sur-attaquant la couche semi-conductrice, ce qui induit naturellement un phénomène de dopage des zones de sur-attaque. En procédant de la sorte, les structures et les zones semi-conductrice de collecte sont réalisées simultanément et sont auto-alignées. En outre, les structures peuvent servir pour porter les zones semi-conductrices de collecte à un potentiel prédéterminé pour le fonctionnement des jonctions PN.

Selon un autre mode de réalisation :
■ la structure métallique comporte des structures (réseau de poutrelles, de plots ou de trous, etc...) espacées entre elles, la géométrie et l'espacement des structures entre elles étant choisis de sorte que les zones de concentration de champ sont réalisées sous les structures ;
■ et les zones semi-conductrices sont réalisées entre les structures et présentent la même topologie que l'espace entre celles-ci.

Notamment, les zones semi-conductrices sont électriquement isolées des structures.

En d'autres termes, ce mode de réalisation est adapté au cas où le champ magnétique est confiné sous les structures. De façon similaire à la réalisation précédente, la fabrication d'un tel dispositif peut être grandement simplifiée par l'utilisation des structures métalliques comme masque lors d'une étape d'implantation ionique et ainsi permettre un auto-alignement structures et des jonctions de collecte ainsi créées.

Selon un mode de réalisation, le photodétecteur comporte, pour chaque surface élémentaire de détection d'une matrice de détection, un conducteur traversant le photodétecteur depuis la couche réflectrice jusqu'au moins une zone semi-conductrice de collecte. Notamment, le conducteur traverse la couche semi-conductrice jusqu'à une structure, les structures associées à la surface élémentaire de détection étant aptes à être connectées électriquement entre elles. Par ailleurs, le conducteur peut comporter, du côté de la couche réfléchissante, une surface de reprise de contact pour l'hybridation du photodétecteur sur un circuit électronique.

En d'autres termes, grâce à la présence des jonctions PN qui permettent la collecte des porteurs de charge, il est possible de collecter le courant généré depuis la face opposée à celle où est agencée la structure métallique et ainsi prévoir une hybridation.

Selon un mode de réalisation de l'invention, la partie de la structure métallique associée à chaque surface élémentaire de détection d'une matrice de détection comporte des zones de motifs parallèles d'orientations différentes, notamment des zones de motifs d'orientations sensiblement perpendiculaires les unes par rapport aux autres. Grâce à des motifs d'orientations différentes, il est ainsi possible de détecter plusieurs polarisations du rayonnement électromagnétique incident au sein d'un même pixel.

Selon un autre mode de réalisation de l'invention, la partie de la structure métallique associée à chaque surface élémentaire de détection d'une matrice de détection comporte des éléments longilignes formant des contours fermés concentriques, notamment des contours sensiblement de forme carrée ou circulaire. Notamment, les contours sont de forme carrée, un conducteur électrique étant formé dans une diagonale desdits contours. Le photodétecteur est ainsi non sélectif en polarisation. Si le carré constitue une forme privilégiée pour les contours fermés concentriques en raison du taux de remplissage optimal qu'il procure, il peut cependant perturber la résonnance du mode plasmon au niveau de ses coins, inconvénient dont sont dépourvus les cercles concentriques. Pour éviter de perturber encore plus la résonnance, les carrés sont connectés électriquement entre eux par un conducteur placé dans une zone où il existe déjà une perturbation, à savoir leur diagonale.

D'autres structures plasmon peuvent être utilisées pour obtenir une non sélectivité en polarisation, comme par exemple un réseau de plots métalliques rectangulaires comme décrit dans l'article de Jérome Le Perchec, "Plasmon-based photosensors comprising a very thin semiconducting region ", Appl. Phys. Lett. 94, 181104 (2009), ou encore un réseau de trous formés dans un film métallique, complémentaire du réseau de plots.

Selon un autre mode de réalisation, la partie de la structure métallique associées à chaque surface élémentaire de détection d'une matrice de détection comporte des motifs parallèles, l'orientation des motifs d'une surface élémentaire de détection étant différente de l'orientation des motifs d'une surface de détection adjacente, et notamment perpendiculaire. Il est ainsi obtenu des pixels adjacents qui ne sont pas sensibles aux mêmes polarisations. Il est alors possible de combiner les signaux issus de pixels adjacents afin d'obtenir une détection du rayonnement selon plusieurs directions de polarisation.

Selon un autre mode de réalisation, la partie de la structure métallique associée à chaque surface élémentaire de détection d'une matrice de détection comporte des motifs parallèles, la périodicité spatiale des motifs d'une surface élémentaire de détection étant différente de la périodicité spatiale des motifs d'une zone élémentaire de détection adjacente. De cette manière, des pixels adjacents ne sont pas sensibles à la même longueur d'onde. Il devient alors possible de combiner les signaux issus de pixels adjacents afin d'obtenir une détection du rayonnement spectralement plus large, tout en conservant le confinement de champ électromagnétique dans la couche semi-conductrice, ou encore de faire une détection multispectrale du rayonnement.

La couche semi-conductrice et les zones semi-conductrices sont avantageusement constituées de CdZnTe ou de CdHgTe.

Le photodétecteur comporte éventuellement une couche d'accord diélectrique, formée entre la couche réflectrice et la couche semi-conductrice. Cette couche d'accord permet de régler la fréquence optique à laquelle le rayonnement détecté entre en résonance avec la géométrie de la structure métallique. Ainsi, la géométrie des structures plasmons, mais aussi l'épaisseur de cette couche diélectrique participent toutes deux au dimensionnement du photodétecteur, notamment concernant la gamme spectrale de sensibilité.

### BREVE DESCRIPTION DES FIGURES

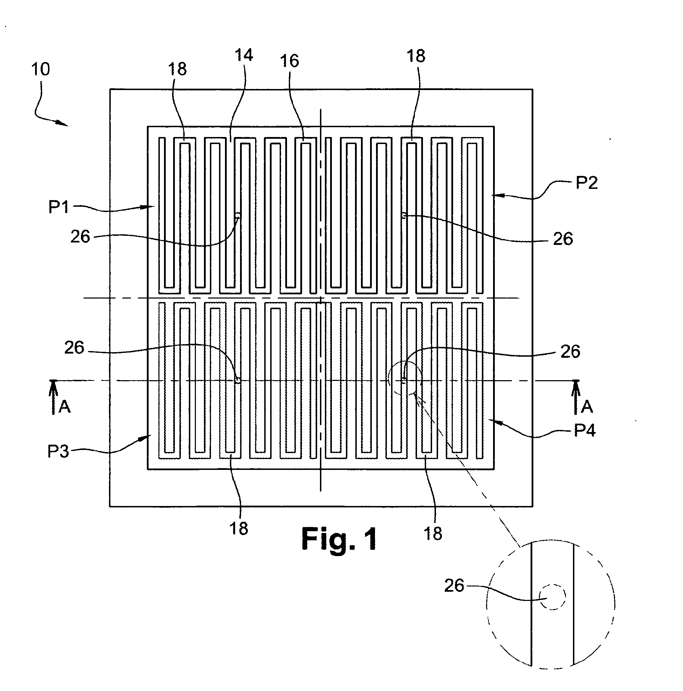

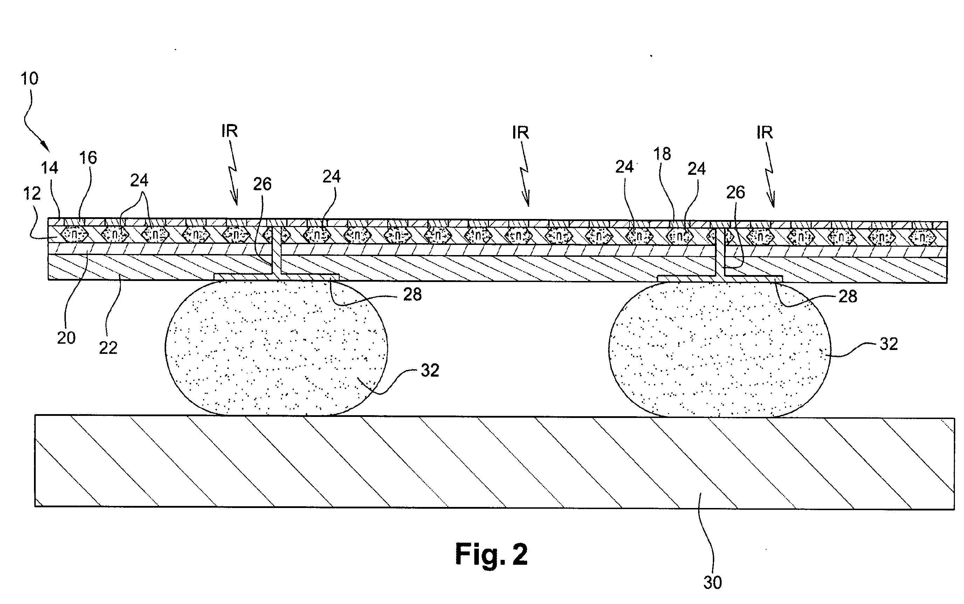

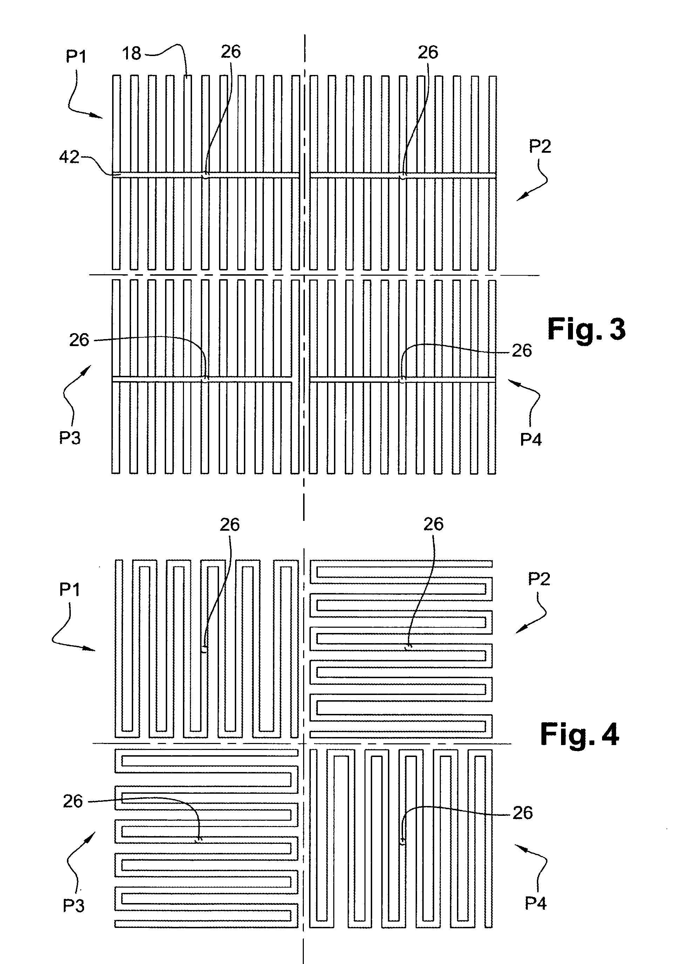

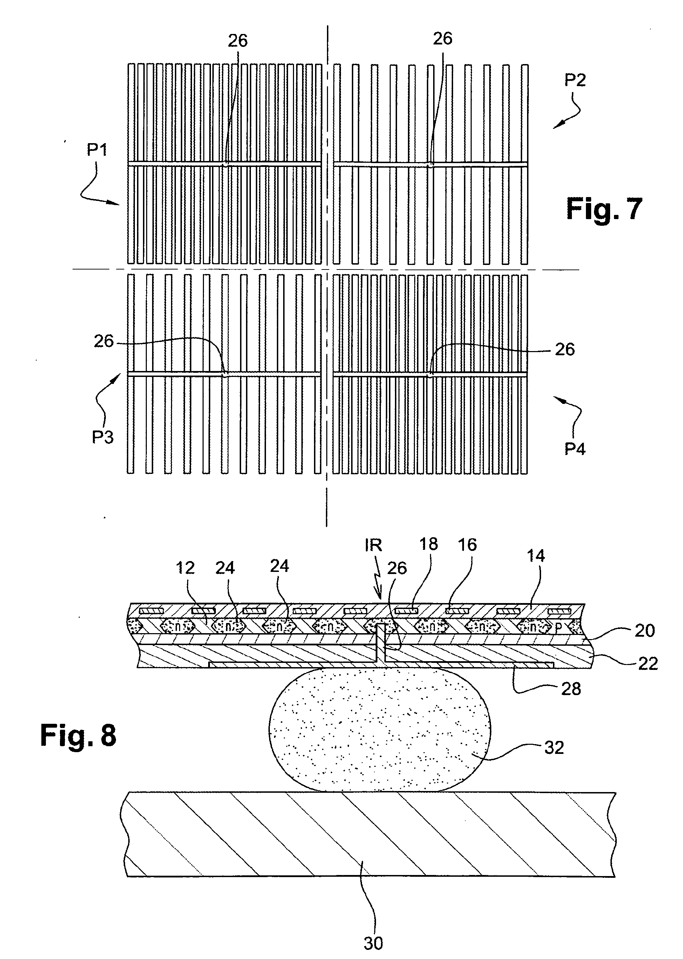

La présente invention sera mieux comprise à la lecture de la description qui suit, donnée uniquement à titre d'exemple, et réalisée en relation avec les dessins annexés, dans lesquels des références identiques désignent des éléments identiques ou analogue, et dans lesquels :
■ la figure 1 est une vue schématique de dessus d'un photodétecteur selon l'invention ;
■ la figure 2 est une vue en section du photodétecteur de la figure 1, selon l'axe A-A ;
■ les figures 3 à 7 sont des vues schématiques de dessus de plusieurs géométries de structure plasmon selon l'invention ; et
■ la figure 8 est une vue schématique en section d'un photodetecteur selon un second mode de réalisation.

### DESCRIPTION DETAILLEE DE L'INVENTION

Un photodétecteur bidimensionnel selon l'invention est illustré aux figures 1 et 2 sous la référence générale **10.** Dans cet exemple, un photodétecteur matriciel de 2 x 2 pixels **P1**, **P2, P3, P4** est représenté.

Le photodétecteur **10** comporte :
■ une couche semi-conductrice absorbante **12** de quelques centaines de nanomètres d'épaisseur, dans laquelle les photons incidents créent des paires électron-trou ; il s'agit par exemple d'une couche semi-conductrice dopée p réalisée en CdHgTe pour la détection d'un rayonnement infrarouge moyen (longueur d'onde comprise entre 3 et 5 micromètres) et/ou lointain (longueur d'onde comprise entre 8 et 10 micromètres) ;
■ une couche isolante de passivation **14,** déposée sur la couche semi-conductrice **12** et de quelques dizaines de nanomètres d'épaisseur ou plus;
■ une structure métallique **16,** par exemple réalisée en or. La structure **16** comporte, pour chaque pixel **P1, P2, P3, P4,** des poutrelles **18** métalliques identiques, rectilignes, parallèles, de section transversale rectangulaire, et raccordées entre elles de manière à former un serpentin. La structure **16** forme avec la couche semi-conductrice **12** un résonateur par excitation d'un mode plasmon de surface, comme cela est connu en soi dans l'état de la technique ;
■ une couche diélectrique d'accord **20,** de quelques dizaines de nanomètres d'épaisseur, déposée sous la couche semi-conductrice **12,** par exemple une couche réalisée en CdTe ; et
■ une couche réflectrice **22,** par exemple un réseau de Bragg ou une couche métallique réfléchissante, déposée sous la couche d'accord **20.**

Les dimensions et l'espacement des poutrelles **18** de la structure métallique **16** et la distance à la couche réflectrice **22** sont sélectionnés pour que le champ électromagnétique **IR** issu d'un rayonnement électromagnétique incident sur la face avant du photodétecteur, c'est-à-dire la face pourvue de la structure **16,** soit confiné dans la couche absorbante **12** entre les poutrelles **18** et sur une faible épaisseur, notamment une épaisseur comprise entre 100 et 500 nanomètres.

Les structures plasmon sont connues de l'état de l'état de la technique et ne seront donc pas décrites plus en détail par la suite pour des raisons de concision. Pour plus de détails sur le fonctionnement d'une structure plasmon, on pourra par exemple se référer aux documents WO 2004/012275 et FR 2 842 945.

Le photodétecteur comporte en outre une pluralité de zones semi-conductrices **24** formées dans la couche semi-conductrice **12** et présentant un dopage différent de celle-ci, par exemple des zones en CdHgTe avec un dopage n. Les zones semi-conductrices **24** sont formées sous les poutrelles **18,** de préférence au contact de celles-ci, et présentent la même topologie de celles-ci. Ainsi dans le mode de réalisation décrit, il y a une zone semi-conductrice **24** par pixel **P1, P2, P3, P4,** cette zone présentant une topologie en serpentin identique à celle représentée à la figure 1 pour les pixels.

De par le confinement du champ électromagnétique, l'absorption du rayonnement incident **IR,** et donc la création de porteurs de charges, est essentiellement réalisée entre les poutrelles **18.** Le matériau dopé p de la couche **12** et les zones **24** forment par ailleurs une jonction PN qui permet la collecte de porteurs de charge. Ainsi, il existe dans la couche **12** une jonction PN sur la totalité de la surface des zones où sont crées les porteurs de charge. Du fait de cette proximité immédiate entre les zones de création de charge et les zones de collecte, la distance que doivent parcourir les porteurs de charge pour être collectés est minimale. Le temps de réponse du photodétecteur est donc optimisé.

En outre, puisque le champ électromagnétique est confiné entre les poutrelles **18,** et que les zones semi-conductrices **24** sont placées sous les poutrelles **18,** il existe une coïncidence entre le volume de collecte du photocourant et du courant d'obscurité. Une réduction du bruit est donc obtenue.

La différence de potentiel entre le matériau dopé p et le matériau dopé n de la couche **12,** et donc la différence de potentiel appliquée aux jonctions PN, est avantageusement réalisée au moyen d'une électrode périphérique distincte (non représentée), aménagée dans ou sur la couche **12** et portée à un premier potentiel, et des poutrelles **18,** portées à un second potentiel.

Par ailleurs, un via métallique **26** formant conducteur, par exemple en platine, est par ailleurs formé pour la zone semi-conductrice **24** de chaque pixel **P1, P2, P3, P4.** Le via **26** s'étend depuis la couche réflectrice **22** jusqu'au moins la zone **24** jusqu'à la poutrelle **18** du pixel.

On notera que l'épaisseur de la couche de passivation **14** peut être réduite, notamment pour optimiser le couplage entre la structure métallique **16** et la couche semi-conductrice **12.** Dans certaines configurations, cette couche de passivation **14** peut même être omise, la structure métallique **16** étant alors formée directement sur la couche semi-conductrice **12.**

Des reprises de contact métalliques **28** sont par ailleurs formées dans le prolongement des via **26** pour l'hybridation du photodétecteur **10** sur un circuit de lecture **30** au moyen de billes de soudure **32,** par exemple en indium.

Il est important de noter que les charges collectées par les jonctions PN doivent rejoindre les via métalliques **26** pour leur collecte finale. De fait, lesdites charges empruntent le chemin électrique le moins résistif, à savoir les poutrelles **18** qui font donc partie du dispositif de collecte des charges. Toutefois, à la différence de l'état de la technique, la seule contrainte de construction des poutrelles **18** est ici dictée par le rôle optique que l'on souhaite leur conférer. En effet, la géométrie et l'espacement de ces poutrelles sont tout d'abord choisis pour définir des zones de concentration de champ électromagnétique dans lesquels les photons sont absorbés. La collecte des porteurs de charge est optimale en termes de temps de diffusion lorsque les zones de collecte présentent, dans la couche semi-conductrice **12,** une topologie complémentaire à celles des zones de confinement de champ, à savoir dans l'exemple décrit une topologie identique à celles des poutrelles **18.** En procédant ainsi, le temps de réponse du photodétecteur est toujours optimal pour la topologie de poutrelle adoptée, et plus généralement la topologie adoptée pour la structure plasmon. La seule contrainte sur cette structure est donc uniquement de nature optique.

En variante, une épaisseur réduite, de l'ordre de quelques nanomètres, de la couche de passivation **14** est réalisée entre les poutrelles **18** et la couche semi-conductrice **12,** notamment pour optimiser le couplage entre ces deux éléments. On notera cependant que cette épaisseur réduite de passivation ne perturbe sensiblement pas le phénomène de résonnance du mode plasmon. Dans ce cas, la polarisation de la zone semiconductrice **24** se fait en utilisant le via **26.**

Par ailleurs, la couche d'accord **20,** et plus particulièrement son épaisseur, peut permettre de choisir la fréquence du rayonnement incident qui entre en résonance avec les plasmons de surface de la structure métallique **16.** On pourra se référer pour plus de précision au document « *Résonances photoniques dans les réseaux métalliques ; théorie et application à la photodétection ultrarapide* », de Stéphane Collin, Thèse Université de Paris 6, 2002

On notera que la couche d'accord **20** est facultative, dépendant de la géométrie précise des structures plasmon utilisées, comme par exemple décrit dans la publication de J. Le Perchec et al, "Plasmon-based photosensors comprising a very thin semiconducting region", Appl. Phys. Lett. 94, 181104 (2009). On notera également que dans le cas où la couche réflectrice **22** est métallique, la couche d'accord **20** peut ne pas jouer de rôle optique mais devient de ce fait une couche de passivation isolante d'épaisseur réduite.

En fonctionnement, la face avant du photodétecteur **10,** c'est-à-dire celle pourvue de la structure métallique **16,** est soumise à un rayonnement à détecter. Le champ électromagnétique incident est alors confiné entre les poutrelles **18** sur une faible épaisseur. Dans le volume ainsi défini, des paires électron-trou sont générées par l'absorption de photons par le matériau semiconducteur de la couche **12.** Périodiquement, une différence de potentiel est appliquée entre la couche **12** et les zones semi-conductrices **24.** Les porteurs de charge minoritaires diffusent alors jusqu'aux zones **24** pour leur collecte au moyen des via **26.** On notera que le champ électrique qui règne dans la zone de charge d'espace de la jonction PN permet à lui seul la collecte des photoporteurs minoritaires.

Il a été décrit une poutrelle **18** sous la forme de serpentin pour chaque pixel. Cette forme en serpentin permet en effet une continuité électrique sur tout le pixel, dans la mesure où une poutrelle **18** de pixel est également utilisée pour polariser la zone semi-conductrice **24** agencée sous elle.

D'autres formes sont envisageables. Par exemple, comme cela est illustré à la figure 3, dans laquelle pour chaque pixel **P1, P2, P3, P4,** il peut être prévu un ensemble de poutrelles **18** identiques, rectilignes, parallèles et de section transversale rectangulaire, électriquement connectées entre elle par un conducteur rectiligne central **42.** De même, pour chaque pixel **P1, P2, P3, P4,** il peut être prévu une structure plasmon en forme de peigne.

Il a été décrit des modes de réalisation dans lesquelles la structure métallique plasmon prend majoritairement la forme de poutrelles identiques, rectilignes, parallèles et régulièrement espacées (serpentins ou poutrelles distinctes raccordées). Cette géométrie présente cependant une sélectivité en polarisation. Notamment, la composante du rayonnement électromagnétique polarisée perpendiculairement aux poutrelles n'est que faiblement détectée. D'autres types de géométries de la structure métallique sont cependant possibles en fonction de l'application visée.

Notamment, dans un mode de réalisation illustré à la figure 4, la structure métallique présente des orientations différentes d'un pixel à l'autre, et avantageusement des orientations perpendiculaires pour détecter des polarisations perpendiculaires.

En combinant les signaux issus de quatre pixels adjacents **P1, P2, P3, P4,** il est ainsi obtenu un « macropixel » carré de 2 pixels par 2 pixels, dont le signal contient les polarisations perpendiculaires du rayonnement incident.

Une manière de combiner les signaux de plusieurs pixels afin de former un macropixel est de connecter électriquement les reprises de contact **28** de ces pixels ou de prévoir dans le circuit de lecture **30** des pistes électriques connectant en parallèle les billes de soudure **32** correspondantes. Les zones semiconductrices **24** des pixels sont alors connectées électriquement en parallèle, formant ainsi le macropixel. Le taux de remplissage optique et/ou la réponse spectrale du détecteur, ou encore la sensibilité en polarisation du détecteur sont ainsi optimisés. Cette connexion en parallèle des zones semi-conductrices peut par ailleurs être permanente ou non. Par exemple, les zones semi-conductrices peuvent être mises en parallèle à l'aide d'interrupteurs pilotables.

D'autres types d'orientations sont possibles, par exemple pour détecter deux rayonnements électromagnétiques de polarisations rectilignes différentes. L'orientation des poutrelles est alors choisie en fonction de la polarisation de ces champs.

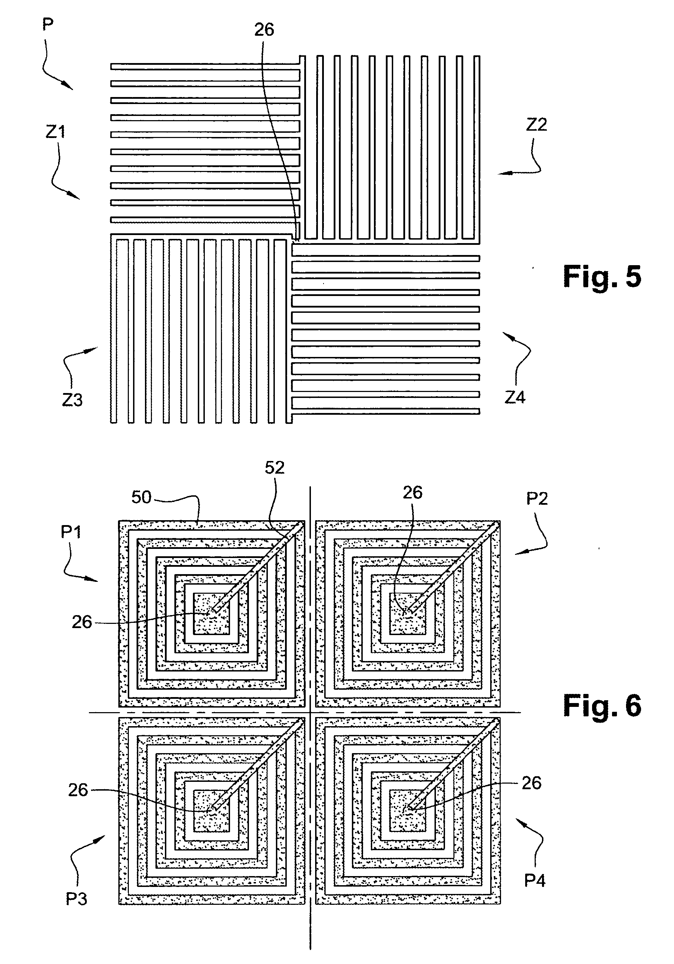

Plutôt que de détecter des polarisations différentes en combinant les signaux issus de pixels adjacents, la détection de polarisations différentes peut être obtenue directement à l'aide d'un seul pixel **P** ayant pour structure plasmon quatre peignes **Z1, Z2, Z3, Z4,** perpendiculaires, une dent d'un peigne servant de base à un peigne adjacent, comme cela est illustré à la figure 5. Le via **26** est placé au centre du pixel **P** et celui-ci comprend ainsi des poutrelles d'orientations différentes, perpendiculaires dans cet exemple.

Afin de rendre la détection indépendante de la polarisation du rayonnement incident, des poutrelles **50** forment pour chaque pixel **P1, P2, P3, P4** des contours fermés concentriques et électriquement connectés, comme cela est illustré à la figure 6. Afin de maximiser le taux de remplissage du photodétecteur en pixels, les contours fermés sont avantageusement de forme carrée, bien que d'autres types de contours puissent être envisagés, comme par exemple des contours circulaires concentriques ou encore des réseaux de plots de forme définis. De manière avantageuse, lorsque les poutrelles **50** sont de forme carrée, un conducteur **52** est agencé sur une de leur diagonale pour assurer leur connexion électrique afin de perturber au minimum de phénomène de résonnance du mode plasmon.

Par ailleurs, la largeur et l'espacement entre les poutrelles règlent la fréquence de résonance des plasmons de surface, et donc la fréquence à laquelle le rendement quantique du photodétecteur présente un gain élevé. Ainsi, prévoir une largeur et un espacement uniques pour la structure métallique implique une application du photodétecteur à une gamme prédéterminée de fréquences. Il peut être souhaité un photodétecteur sensible à plusieurs gammes de fréquences.

A cet effet, la structure métallique peut comporter des zones dans lesquelles les poutrelles présentent une première largeur et/ou un premier espacement en alternance avec d'autres zones où les poutrelles présentent une largeur et/ou un espacement différent afin d'obtenir une détection sensible à plusieurs gammes de fréquences. La figure 7 illustre le cas d'une détection sensible à deux gammes de fréquences, quatre pixels adjacents ayant leurs signaux combinés pour obtenir un macropixel de deux pixels sur deux pixels. On notera que l'agencement de la figure 5 avec son unique via métallique **26** peut être également utilisé pour obtenir un pixel sensible à deux gammes de fréquences. On notera également qu'une forme de serpentin ou de peigne est également utilisable pour la structure plasmon.

Il est en outre possible de combiner les modes de réalisation précédents afin d'obtenir une détection selon plusieurs polarisations et plusieurs gammes de fréquences.

Un exemple de procédé de fabrication d'un détecteur en CdHgTe dans lequel les zones semi-conductrices **24** dopées n sont formées dans la couche semiconductrice dopé p **12** sous la structure plasmon **16** est le suivant :
1. croissance de la couche absorbante **12** en CdHgTe sur un substrat CdZnTe par épitaxie par jets moléculaires ;
2. dépôt par pulvérisation cathodique de la couche d'accord diélectrique **20** suivi du dépôt de la couche réflectrice **22** avec la même méthode de dépôt;
3. création d'un contact électrique périphérique sur la couche **12** par gravure de la couche **20** jusqu'au matériau **24** puis dépôt du métal pour la prise de contact ;
4. recuit de l'ensemble pour obtenir un dopage p dans la couche en CdHgTe, par exemple entre 200°C et 300°C pendant plusieurs heures ;
5. usinage des via **26** jusque la couche en CdHgTe, ce qui induit la création des zones semi-conductrices annulaires de même polarité que la zone **24,** et formation des reprises de contact **28 ;**
6. hybridation de l'ensemble obtenu sur le circuit **30** au moyen des billes de soudure **32 ;**
7. amincissement du substrat du circuit **30 ;**
8. dépôt de la couche de passivation **14** sur la couche absorbante **12 ;**
9. dépôt d'une résine, suivi d'une insolation avec un masque présentant la topologie de la structure métallique **16 ;**
10. gravure de la couche de passivation **14** débouchant sur la couche absorbante **12** au travers de la résine réticulée, ce qui à pour effet de générer les zones **24** de polarité inverse à **12** alignées sur le motif résine ;
11. dépôt du métal constitutif de la structure métallique **16 ;** et
12. liftoff du métal : retrait de la résine et du métal déposé sur cette dernière et ainsi autoalignement de **16** et **24** car utilisant la même insolation résine.

Il a été décrit la fabrication de via **26** et de surfaces de reprise de contact **28** pour une hybridation sur un circuit de lecture **30.**

En variante, le photodétecteur n'est pas destiné à être hybridé de sorte que les via **26** et les surfaces de contact **28** sont omises. Les porteurs de charge sont alors collectés au moyen de la structure métallique **16.**

Il a été décrit des modes de réalisation dans lesquels le champ électromagnétique est confiné entre les parties pleines de la structure plasmon, par exemple entre des poutrelles, et des zones semi-conductrices de collecte sous les parties pleines de ladite structure, par exemple sous les poutrelles.

En variante, le champ électromagnétique est confiné sous les parties pleines de la structure métallique et les zones semi-conductrices de collecte sont réalisées entre les parties pleines. Par exemple, la figure 8 illustre une vue en section d'un pixel selon un mode de réalisation qui diffère de celui décrit en relation avec les figures 1 et 2 par :
■ les dimensions et l'espacement des poutrelles **18** de la structure métallique **16** qui sont sélectionnés pour que le champ électromagnétique **IR** soit confiné dans la couche absorbante **12** sous les poutrelles **18 ;**
■ la zone semi-conductrice **24** qui est formée entre les poutrelles **18 ;**
■ une couche de passivation **14** qui est plus épaisse ; et
■ les poutrelles **18** qui sont formées dans la couche de passivation **14** de manière à être électriquement isolées de la zone semi-conductrice **24.**

Les porteurs de charge sont collectés par la jonction PN lorsque celle-ci est soumise à une différence de potentiel, puis transitent dans la zone semi-conductrice **24** jusqu'à atteindre le via **26** pour leur collecte finale.

Un procédé de fabrication d'un photodétecteur selon le mode de réalisation illustré à la figure 8 est par exemple le suivant :
1. croissance de la couche absorbante **12** en CdHgTe sur un substrat CdZnTe par épitaxie par jets moléculaires ;
2. dépôt de la couche d'accord diélectrique **20** par pulvérisation cathodique suivi du dépôt de la couche réflectrice **22 ;**
3. création d'un contact électrique périphérique sur la couche **12 ;**
4. recuit de l'ensemble pour obtenir un dopage p dans la couche en CdHgTe, par exemple entre 200°C et 300°C pendant plusieurs heures ;
5. usinage des via **26** jusque la couche en CdHgTe, ce qui induit la création d'une zone semi-conductrice de dopage n autour du via **26,** et formation des reprises de contact **28 ;**
6. hybridation de l'ensemble obtenu sur le circuit **30** au moyen des billes de soudure **32 ;**
7. amincissement du substrat du circuit **30 ;**
8. dépôt de la couche de passivation **14** sur la couche absorbante **12 ;**
9. dépôt d'une couche du métal constitutif de la structure plasmon sur la couche **14 ;**
10. dépôt d'une résine, suivi d'une insolation avec un masque présentant la topologie de la structure métallique **16 ;**
11. retrait de la portion de résine insolée ;
12. gravure du métal dans la zone où la résine a été retirée, cette gravure étant prolongée dans la couche semi-conductrice **12** de manière à former les zones semi-conductrices **24.** En variante, les zones semi-conductrices **24** sont réalisées par implantation ionique ;
13. insolation et retrait de la résine restante de manière à faire apparaître les poutrelles **18;** et
14. dépôt d'une nouvelle couche d'isolant afin d'encapsuler les poutrelles **18** dans la couche de passivation **14.**

Il a été décrit des modes de réalisation dans lesquelles la couche semi-conductrice **12** est dopé p et les zones semi-conductrices sont dopées n. Bien entendu, l'invention s'applique également dans le cas d'une couche semi-conductrice dopée n et de zones semi-conductrices **24** dopées p.

## Revendications

1. Photodétecteur apte à détecter un rayonnement électromagnétique comprenant :
■ une couche semi-conductrice dopée (12) d'absorption dudit rayonnement apte à transformer ledit rayonnement en porteurs de charge ;
■ une couche réflectrice (22) du rayonnement incident non absorbé par la couche semi-conductrice (12) en direction de cette dernière, agencée sous la couche semi-conductrice (12); et
■ une structure métallique (16) agencée sur la couche semi-conductrice (12), et formant avec la couche semi-conductrice (12) un résonateur par excitation d'un mode plasmon de surface de manière à concentrer le rayonnement électromagnétique incident sur la structure métallique (16) dans des zones de concentration de champ de la couche semi-conductrice (12),
***caractérisé* en ce que** des zones semi-conductrices de collecte (24) des porteurs de charge, de dopage opposé au dopage de la couche semi-conductrice (12), sont formées dans ladite couche semi-conductrice (12) et présentent une topologie complémentaire de celle des zones de concentration de champ.

2. Photodétecteur selon la revendication 1, ***caractérisé :***
■ **en ce que** la structure métallique (16) comporte des structures (18), espacées les unes des autres, la géométrie et l'espacement des structures (18) étant choisis de sorte que les zones de concentration de champ sont réalisées entre les structures ;
■ et en ce que les zones semi-conductrices de collecte (24) sont réalisées sous les structures (18) et présentent la même topologie que celles-ci.

3. Photodétecteur selon la revendication 2, ***caractérisé* en ce que** les structures (18) sont agencées au contact des zones semi-conductrices de collecte (24).

4. Photodétecteur selon la revendication 1, ***caractérisé :***
■ **en ce que** la structure métallique (16) comporte des structures (18) espacées les unes des autres, la géométrie et l'espacement des structures (18) étant choisis de sorte que les zones de concentration de champ sont réalisées sous les structures (18) ;
■ et en ce que les zones semi-conductrices (24) sont réalisées entre les structures (18) et présentent la même topologie que l'espace entre celles-ci.

5. Photodétecteur selon la revendication 4, ***caractérisé* en ce que** les zones semi-conductrices (24) sont électriquement isolées des structures, notamment au moyen d'une couche de passivation (14).

6. Photodétecteur selon l'une quelconque des revendications précédentes, ***caractérisé* en ce qu'**il comporte, pour chaque surface élémentaire de détection (P1, P2, P3, P4) d'une matrice de détection, un conducteur (26) traversant le photodétecteur depuis la couche réflectrice (22) jusqu'au moins une zone semi-conductrice de collecte (24).

7. Photodétecteur selon les revendications 3 et 6, ***caractérisé* en ce que** le conducteur traverse la couche semi-conductrice (12) jusqu'à une structure (18), les structures (18) associée à la surface élémentaire de détection (P1, P2, P3, P4) étant aptes à être connectées électriquement entre elles.

8. Photodétecteur selon la revendication 6 ou 7, ***caractérisé* en ce que** le conducteur (26) comporte du côté de la couche réfléchissante (22), une surface de reprise de contact (28) pour l'hybridation du photodétecteur sur un circuit électronique (30).

9. Photodétecteur selon l'une quelconque des revendications précédentes, ***caractérisé* en ce que** la partie de la structure métallique associée à chaque surface élémentaire de détection (P1, P2, P3, P4) d'une matrice de détection comporte des zones de motifs parallèles d'orientations différentes, notamment des zones de motifs d'orientations sensiblement perpendiculaires les unes par rapport aux autres.

10. Photodétecteur selon l'une quelconque des revendications 1 à 8, ***caractérisé* en ce que** la partie de la structure métallique associées à chaque surface élémentaire de détection (P1, P2, P3, P4) d'une matrice de détection comporte des éléments longilignes formant des contours fermés concentriques, notamment des contours sensiblement de forme carrée ou circulaire.

11. Photodétecteur selon les revendications 7 et 10, ***caractérisé* en ce que** les contours sont de forme carrée, un conducteur électrique étant formé dans une diagonale desdits contours.

12. Photodétecteur selon l'une quelconque des revendications 1 à 8, ***caractérisé* en ce que** la partie de la structure métallique associée à chaque surface élémentaire de détection (P1, P2, P3, P4) d'une matrice de détection comporte des motifs parallèles, l'orientation des motifs d'une surface élémentaire de détection étant différente de l'orientation des motifs d'une surface de détection adjacente, et notamment perpendiculaire.

13. Photodétecteur selon l'une quelconque des revendications 1 à 8, ***caractérisé* en ce que** la partie de la structure métallique associées à chaque surface élémentaire de détection (P1, P2, P3, P4) d'une matrice de détection comporte des motifs parallèles, la périodicité spatiale des motifs d'une surface élémentaire de détection étant différente de la périodicité spatiale des motifs d'une surface élémentaire de détection adjacente.

14. Photodétecteur selon l'une quelconque des revendications précédentes, ***caractérisé* en ce que** la couche semi-conductrice (12) et les zones semi-conductrices (24) sont constituées de CdZnTe ou de CdHgTe.

## Claims

1. A photodetector capable of detecting electromagnetic radiation comprising:
■ a doped semiconductor absorption layer (12) for said radiation, capable of converting said radiation into charge carriers;
■ a reflective layer (22) that reflects the incident radiation that is not absorbed by semiconductor layer (12) towards the latter, located underneath semiconductor layer (12); and
■ a metallic structure (16) placed on semiconductor layer (12) that forms, with semiconductor layer (12), a surface plasmon resonator so as to concentrate the incident electromagnetic radiation on metallic structure (16) in the field concentration zones of semiconductor layer (12),
***characterized* in that** semiconductor zones (24) for collecting charge carriers are oppositely doped to the doping of semiconductor layer (12) and are formed in said semiconductor layer (12) and have a topology that complements that of the field concentration zones.

2. The photodetector as claimed in claim 1, ***characterized:***
■ **in that** metallic structure (16) comprises spaced-apart structures (18), the geometry and spacing of the structures (18) relative to each other being selected so that the field concentration zones are produced between the structures;
■ and in that semiconductor collecting zones (24) are produced underneath structures (18) and have the same topology as them.

3. The photodetector as claimed in claim 2, ***characterized* in that** structures (18) are located so that they are in contact with semiconductor collecting zones (24).

4. The photodetector as claimed in claim 1, ***characterized:***
■ **in that** metallic structure (16) comprises spaced-apart structures (18), the geometry and spacing of the structures (18) relative to each other being selected so that the field concentration zones are produced underneath structures (18);
■ and in that semiconductor zones (24) are produced between structures (18) and have the same topology as the space between them.

5. The photodetector as claimed in claim 4, ***characterized* in that** semiconductor zones (24) are electrically insulated from the structures, especially by means of a passivation layer (14).

6. The photodetector as claimed in any of the above claims, ***characterized* in that** it comprises, for each elementary detection surface (P1, P2, P3, P4) of a detection array, a conductor (26) that passes through the photodetector from reflective layer (22) to at least one semiconductor collecting zone (24).

7. The photodetector as claimed in claims 3 and 6, ***characterized* in that** the conductor passes through semiconductor layer (12) to a structure (18) with structures (18) associated with the elementary detection surface (P1, P2, P3, P4) being capable of being electrically connected to each other.

8. The photodetector as claimed in claim 6 or 7, ***characterized* in that** conductor (26) comprises, on the same side as reflective layer (22), a contact pad surface (28) for hybridizing the photodetector on an electronic circuit (30).

9. The photodetector as claimed in any of the above claims, ***characterized* in that** the part of the metallic structure associated with each elementary detection surface (P1, P2, P3, P4) of a detection array comprises areas having differently orientated parallel patterns, especially areas having patterns that are substantially oriented at right angles to each other.

10. The photodetector as claimed in any of claims 1 to 8, ***characterized* in that** the part of the metallic structure associated with each elementary detection surface (P1, P2, P3, P4) of a detection array comprises long thin elements forming closed concentric contours, especially contours that have a substantially square or circular shape.

11. The photodetector as claimed in claims 7 and 10, ***characterized* in that** the contours have a square shape with an electrical conductor being formed along a diagonal of said contours.

12. The photodetector as claimed in any of claims 1 to 8, ***characterized* in that** the part of the metallic structure associated with each elementary detection surface (P1, P2, P3, P4) of a detection array comprises parallel patterns with the orientation of the patterns of one elementary detection surface being different to the orientation of the patterns of the adjacent detection surface, especially at right angles.

13. The photodetector as claimed in any of claims 1 to 8, ***characterized* in that** the part of the metallic structure associated with each elementary detection surface (P1, P2, P3, P4) of a detection array comprises parallel patterns with the spatial periodicity of the patterns of one elementary detection surface being different to the spatial periodicity of the patterns of the adjacent elementary detection surface.

14. The photodetector as claimed in any of the above claims, ***characterized* in that** semiconductor layer (12) and semiconductor zones (24) are made of CdZnTe or CdHgTe.

## Patentansprüche

1. Fotodetektor, der elektromagnetische Strahlung erfassen kann, Folgendes umfassend:
■ eine dotierte Halbleiterschicht (12) zur Absorption der Strahlung, die die Strahlung in Ladungsträger umwandeln kann;
■ eine Reflektorschicht (22) für die nicht von der Halbleiterschicht (12) absorbierte, in Richtung auf diese einfallende Strahlung, die unter der Halbleiterschicht (12) ausgebildet ist; und
■ eine Metallstruktur (16), die auf der Halbleiterschicht (12) ausgebildet ist und mit der Halbleiterschicht (12) durch Erregung einer Oberflächenplasmonmode einen Resonator bildet, um die auf die Metallstruktur (16) einfallende elektromagnetische Strahlung in Feldkonzentrationszonen der Halbleiterschicht (12) zu konzentrieren,
**dadurch gekennzeichnet, dass** in der Halbleiterschicht (12) zur Dotierung der Halbleiterschicht (12) entgegengesetzt dotierte Halbleiterkollektorzonen (24) für die Ladungsträger ausgebildet sind und eine Topologie aufweisen, die zu derjenigen der Feldkonzentrationszonen komplementär ist.

2. Fotodetektor nach Anspruch 1, **dadurch gekennzeichnet, dass**:
■ die Metallstruktur (16) voneinander beabstandete Strukturen (18) umfasst, wobei die Geometrie und die Beabstandung der Strukturen (18) so gewählt sind, dass die Feldkonzentrationszonen zwischen den Strukturen gebildet sind;
■ und die Halbleiterkollektorzonen (24) unter den Strukturen (18) gebildet sind und dieselbe Topologie aufweisen wie diese.

3. Fotodetektor nach Anspruch 1, **dadurch gekennzeichnet, dass** die Strukturen in Kontakt mit den Halbleiterkollektorzonen (24) ausgebildet sind.

4. Fotodetektor nach Anspruch 1, **dadurch gekennzeichnet:**
■ **dass** die Metallstruktur (16) voneinander beabstandete Strukturen (18) umfasst, wobei die Geometrie und die Beabstandung der Strukturen (18) so gewählt sind, dass die Feldkonzentrationszonen unter den Strukturen (18) gebildet sind;
■ und dass die Halbleiterzonen (24) zwischen den Strukturen (18) gebildet sind und dieselbe Topologie wie der Raum zwischen diesen aufweisen.

5. Fotodetektor nach Anspruch 4, **dadurch gekennzeichnet, dass** die Halbleiterzonen (24) insbesondere mittels einer Passivierungsschicht (14) von den Strukturen elektrisch isoliert sind.

6. Fotodetektor nach einem der vorhergehenden Ansprüche, **dadurch gekennzeichnet, dass** er für jedes Erfassungsflächenelement (P1, P2, P3, P4) einer Erfassungsmatrix einen Leiter (26) umfasst, der von der Reflektorschicht (22) bis zu mindestens einer Halbleiterkollektorzone (24) durch den Fotodetektor verläuft.

7. Fotodetektor nach den Ansprüchen 3 und 6, **dadurch gekennzeichnet, dass** der Leiter durch die Halbleiterschicht (12) bis zu einer Struktur (18) verläuft, wobei die Strukturen (18), die dem Erfassungsflächenelement (P1, P2, P3, P4) zugeordnet sind, untereinander elektrisch verbunden werden können.

8. Fotodetektor nach Anspruch 6 oder 7, **dadurch gekennzeichnet, dass** der Leiter (26) auf der Seite der Reflektorschicht (22) eine Kontaktwiederbelegungsfläche (28) für die Hybridisierung des Fotodetektors auf einer elektronischen Schaltung (30) umfasst.

9. Fotodetektor nach einem der vorhergehenden Ansprüche, **dadurch gekennzeichnet, dass** der Abschnitt der Metallstruktur, der jedem Erfassungsflächenelement (P1, P2, P3, P4) einer Erfassungsmatrix zugeordnet ist, parallele Zonen von Mustern unterschiedlicher Ausrichtungen, insbesondere Zonen von Mustern mit Ausrichtungen, die im Wesentlichen senkrecht zueinander sind, umfasst.

10. Fotodetektor nach einem der Ansprüche 1 bis 8, **dadurch gekennzeichnet, dass** der Abschnitt der Metallstruktur, der jedem Erfassungsflächenelement (P1, P2, P3, P4) einer Erfassungsmatrix zugeordnet ist, langgestreckte Elemente umfasst, die geschlossene konzentrische Umrisse, insbesondere im Wesentlichen viereckige oder kreisförmige Umrisse bilden.

11. Fotodetektor nach den Ansprüchen 7 und 10, **dadurch gekennzeichnet, dass** die Umrisse von viereckiger Form sind, wobei ein elektrischer Leiter in einer Diagonalen der Umrisse gebildet ist.

12. Fotodetektor nach einem der Ansprüche 1 bis 8, **dadurch gekennzeichnet, dass** der Abschnitt der Metallstruktur, der jedem Erfassungsflächenelement (P1, P2, P3, P4) einer Erfassungsmatrix zugeordnet ist, parallele Muster umfasst, wobei sich die Ausrichtung der Muster eines Erfassungsflächenelements von der Ausrichtung der Muster eines benachbarten Erfassungsflächenelements unterscheidet und insbesondere senkrecht hierzu ist.

13. Fotodetektor nach einem der Ansprüche 1 bis 8, **dadurch gekennzeichnet, dass** der Abschnitt der Metallstruktur, der jedem Erfassungsflächenelement (P1, P2, P3, P4) einer Erfassungsmatrix zugeordnet ist, parallele Muster umfasst, wobei sich die räumliche Periodizität der Muster eines Erfassungsflächenelements von der räumlichen Periodizität der Muster eines benachbarten Erfassungsflächenelements unterscheidet.

14. Fotodetektor nach einem der vorhergehenden Ansprüche, **dadurch gekennzeichnet, dass** die Halbleiterschicht (12) und die Halbleiterzonen (24) aus CdZnTe oder CdHgTe bestehen.
